# EUROPEAN PATENT APPLICATION

(11) **EP 3 722 181 A1**
(43) Date of publication of application: **14.10.2020**
(21) Application number: 20169360.3
(22) Date of filing: 14.04.2020
(51) Int. Cl.: B61L 1/20, G01R 15/18, B61L 19/06, B61L 21/04

(54) **MAGNETO INDUCTIVE PRINCIPLE SAFETY RELAY CURRENT DETECTOR**

(30) Priority: 11.04.2019 NL 2022932
(71) Applicant: VolkerRail Nederland BV, 4131 NJ Vianen (NL)
(72) Inventor: Steentjes, Noël, 4131 NJ Vianen (NL)
(74) Representative: Assendelft, Jacobus H.W.

(57) **Abstract**

The invention relates to a relay box or house or cabinet which is associated with a railway for civil train transport and which contains a large number of relays of which at least one, or all, relays is magnetically associated with an instrument having a magnetic field sensor electrically connected to an electrical circuit that operates according to the magneto inductive principle to measure the current flowing through the relay or through an electrical supply lead of the relay.

## Description

This invention relates to the monitoring of the correct operation or position of an object, e.g. a switch, of a railway, e.g. type UIC 60 and/or rail width 1435 mm, with safety relays (e.g. so-called B-relay or K-relay), in particular relays which are applied at security level in the control and monitoring of switches or crossings, or are used for track occupancy detection, such as a so-called track repeat relay (TPR relay). A safety relay is an essential relay (also called: vital relay).

In particular the invention relates to adding such monitoring or an instrument (in here also called "detector") of it to a system that is already in full operation for at least one year, thus the addition is a modification or extension of the existing system, and the addition e.g. does not require disassembling of the system or part of it. E.g. the addition is simply by clamping or mounting the instrument, e.g. onto a supply lead. E.g. the addition is such that taking the system or object out of service is avoided.

Alternatively, the invention relates to monitoring or measuring the current flowing through an electrical lead of any type in the field of railway or any other field, by using the detector of the invention.

A safety relay (also called "B-relay") is a relay with a security function in a railway security system (including NX safety). B-relays have a very high degree of reliability, and operate for decades, provided they are regularly revised. Important features of B-relays are that they for sure loose contact when the coil is not energized, and the normally closed break contacts ("back contact") open before make contacts ("front contact") are closed. There exist several types of B-relays, with specific properties. The most common type is the 56001-783Gr1. This relay has two coils that operate on 12V DC, four switch contacts ("full contacts"), two make contacts and one break contact. Furthermore, there are B-relays which engage with a delay, disengage with a delay, are suitable for large currents etc. Another type of B-relay is the track relay (TR). This relay is a part of a track circuit, and is "on" when a track section is unoccupied, and falls off as the track section is occupied by a train. In the case of B-relays, in particular the B2 of relays (the "track relay"), a movable element is often used (at the B2 relay the "vane") which is sensitive to magnetism and a resetting force, for example gravity, so that, when the magnetic field generated by the one or more coils of the B-relay fails, this element is no longer held in a deviated position by the magnetic field and moves by the restoring force, such as the force of gravity, causing the B-relay to switch. A so-called B1 relay is usually equipped with a reset spring.

A safety relay is supplied factory-delivered in a sealed casing. The rear wall of the housing is equipped with contact ports that correspond to contact plugs (so-called terminals) that protrude from a contact block (so-called plug board) in the relay box. A B-relay is placed by pressing its rear wall against the contact block so that the terminals are inserted into the contact ports so that the B-relay, via the terminals connected to lead wires, is galvanically (also called: electrically) connected to the corresponding circuit in which the B-relay must be included. If the housing is modified or damaged after it has been delivered by the factory or if the seal is broken, the product concerned will be rejected.

For the internal space of the housing of the B-relay, e.g. one or more of the following applies: is a single internal space; contains one or more of a single or double galvanic magnet coil with e.g. soft iron core, an anchor, a return spring of the anchor, or the anchor executed as or equipped with a so-called "vane" where the force of gravity, instead of a return spring, provides the resetting force to move the anchor in the other position when the magnetic field is switched off by switching off the magnetic coil, a changeover contact, a make contact, a break contact; contains all components of the B-relay; is hermetically sealed with respect to the environment; is sealed against unauthorized access; has a boundary wall that is transparent to visible light; at least one or two, e.g. mutually parallel and/or straight, mounting sleeves extend there through, sealed there from and terminate in the environment through the two opposite end walls, so that in a mounting sleeve a at both sides projecting mounting pin can be inserted (in a relay box for each B-relay a pair of mutually parallel, fixed mounting pins is available onto which a B-relay housing is simply plugged so that its rear wall is placed against the contact block, and then nuts are screwed on out of the front wall of the B-relay housing projecting threaded ends of these mounting pins so that the B-relay housing stays on the mounting pins without slipping); from this space one or more galvanic conductors are inserted through a boundary wall into the environment; only one or more galvanic conductors extend from the space in the environment; the galvanic conductors are galvanically connected to one or more components in this space, such as a magnet coil or a switching contact contains a direction- sensitive relay.

E.g. one or more of the following applies: the relay and the contact block to be arranged for mutual electrical plug connection, for example by means of mutually matching contact ports and contact plugs; the plug connection is made or broken by move to each other or away from each other of the relay and the contact block; the relay has contact ports, the contact block has contact plugs, or vice versa; a contact port is provided by a respective pair from the wall protruding contact lips (so-called prongs); a contact plug is provided by an electrically insulated, wedge-shaped pin projecting from the wall; the pin has an upper contact (top terminal) and a bottom contact (bottom terminal) to each of which a private electricity lead is connected; of a pair is each contact lip electrically connected to its private inside the relay located relay contact; the contact lips are elastically spring-loaded towards each other and are pushed away from each other by the pin so that they clamp the pin elastic springy between them; of a pair makes one contact lip electrical contact with the upper contact (top terminal), the other contact lip makes electrical contact with the lower contact (bottom terminal) of the contact plug; the electric currents of the relay contacts via the pair of contact lips to the electricity lines are electrically insulated from each other; the plug connections are arranged in at least two or three horizontal rows and/or at least two or three vertical columns at one or more of relay and contact block; the plug connections have fixed locations at one or more of relay and contact block; the pattern of the plug connections at relay and contact block is mutually matching and/or identical.

E.g., the rear wall of the B-relay comprises rearward facing contact members, for example pins in a pattern which corresponds to the pattern of forward-facing, e.g. complementary, contact members, such as holes on the front wall of the contact block, so that these members can be mutually galvanically connected, for example the contact pins can be inserted in the contact holes by pressing the B-relay backwards against the contact block in the horizontal direction.

The usual mounting pins on the contact block are e.g. removed, or possibly replaced by longer ones. In case of longer ones, they protrude through the adapter and through the B-relay and a bit ahead of the B-relay, as is customary with a B-relay which is directly mounted on the contact block, ie without the adapter being in between. E.g. the adapter is equipped with mounting pins which e.g. protrude only from the front and/or on which only the B-relay is inserted. E.g., the contact block is attached to the adapter with screws or bolts.

E.g. the B-relay and the contact block are equipped with a provision, also called coding, e.g. mechanically, to ensure that the correct B-relay is mounted, e.g., executed as a unique fit between two of these elements (also called male and female coding), e.g., a unique pattern of protrusions, such as pins, on one element and a corresponding pattern of closely fitting holes on the other element so that merging according to regulations is only possible with corresponding coding; and/or the B-relay is equipped with a female device and the contact block with a male facility, or vice versa.

In the field of railway also other vital relays types are used, having a slightly different design compared to the above explanation, to which the invention is also applicable.

For railway operation purposes, e.g. for control and monitoring of switches or crossings, or for track occupancy detection, it is common to use a separate current sensor (also called: "current clamp") to detect the electrical current that flows through the electrical supply lead of the B-relay that extends outside the sealed housing of the B-relay. Such current clamp (hereafter also called "instrument" or "detector" or "sensor") typically is of non-invasive (also called: "contactless") type, which means that the current clamp lacks any physical contact with the electrical supply lead itself and thus does not penetrate the electrical insulation sleeve with which the electrical supply lead is covered, such that the current clamp detects the electrical current in an indirect rather than a direct manner. E.g. such current clamp is designed such that it can be opened and closed to install it around the electrical supply lead without the need to temporary release the supply lead from the associated electrical circuit.

Relay cabinets, boxes and houses of railways are exposed to mechanical vibrations and shocks caused by passing trains and the internal relays and the external overhead catenary or train supply line and a passing train generate magnetic radiation or disturb magnetic fields of important level and have impact on the design of a current detector or sensor.

FR A 2731974 discloses the placing of a sensor working with Hall effect around a lead wire connected to a safety relay. The sensor reacts to the magnetic field generated by current flowing through the conductor. From practice it is known to put a separate, so-called current clamp on a wire which is connected to a B1 relay. This clamp is also working with Hall effect and constitutes a with FR 2731974 A functionally corresponding sensor. Both types of sensors form a magnetic field sensitive closed ring of weak iron around the conductor.

US4,305,034 and US3,768,011 disclose instruments with field sensors and oscillator circuits. The disclosure of these documents is enclosed in here by reference.

The object of the invention is an improved current clamp of non-invasive type, allowing for locating around or fastening to an electrical lead, e.g. an electrical supply lead, e.g. of an already installed and fully operational safety relay within a relay box or relay cabinet at a railway track. This current clamp is used for relay position monitoring. The improvement is one or more of: fast and reliable installation of the monitoring system; reliability of the monitoring process; independence of the way in which the relay to be monitored is installed; output of the instrument is digital by nature such that an A/D converter is obsolete; the number (counted pulses) at the output is directly related to the measured magnetic field; high accuracy (e.g. in the order of 10nT); small size; inexpensive; low energy consumption; no set/reset signal required; field sensor shows no magnetisation; demagnetizing of the field sensor (e.g. if exposed to a too large current) obsolete; temperature insensitive; no hysteresis; designed to detect switch position (e.g. left or right end position); determination of the state of the train occupancy system; isolated current detection; complies with one or more of: EN 50121 Railway applications - electromagnetic compatibility; EN 50124 Railway applications -Insulation coordination; EN 50125 Railway applications - Environmental conditions for equipment; RLN00138; capacity to reliably detect an electrical current, or current difference, flowing within the supply lead that is connected to the B-relay of less than 5 mA or 20 mA or 100 mA; bi-directional operation; converts in a contactless manner electrical currents through an electrical lead to an analogue or digital output, e.g. according to the 4-20mA standard; a length less than 200 or 150 or 100 millimetre; a width and/or height less than 100 or 75 or 50 millimetre; dimension 90 x 40 x 40 mm (1 x w x h); a weight less than 0.5 or 0.3 or 0.25 gram, e.g. 200 gram.

The instrument is designed such that it can be opened and closed, or differently designed, to install it around the electrical supply lead without the need to temporary release the supply lead from the electrical circuit to which the lead belongs, e.g. in the manner of a pincer, thus comprising two halves that are hingedly connected such that the instrument can be hingedly opened and closed and if opened it can be removed from the lead in radial direction. Different designs are feasible for the same object, e.g without the need to open and close the instrument and/or wherein the instrument is added to and/or removed from the lead in radial direction. E.g., the electrical isolation jacket of the lead remains present and/or the lead stays unchanged.

Applications in the field of railway are e.g.: switch position reading, e.g. in switch distribution cabinets or relay cabinets or relay houses or relay boxes; relay monitoring, e.g. in relay cabinets or relay houses or relay boxes.

The current clamp according to the invention is provided with a magnetic field sensor (in here also called "field sensor" or "sensor") that is part of or associated with an electrical or electronic (hereafter both are meant by "electrical") circuit that operates according to the magneto inductive principle. The circuit is e.g. designed as an oscillation circuit, e.g. of L/R type, and thus a means to provide a clock frequency and/or to provide an oscillating electrical signal within the circuit, e.g. a Schmitt Trigger, is part of the circuit. E.g., the circuit has a bias resistor. Both the circuit and the sensor are part of the current clamp. The means to provide the oscillating electrical signal, and/or the circuit, e.g. provides a rectangular wave oscillating signal.

E.g., the field sensor and the means to provide a clock frequency and/or an oscillating electrical signal are connected in parallel within the circuit, providing a parallel connected unit, and/or the bias resistor and the field sensor or the parallel connected unit are connected in series.

E.g., the instrument provides two or three output levels: "0", "1" and an intermediate level. A "0" is output if the detected current strength is below a first threshold. A "1" is output if the detected current strength is above a second threshold that is above the first threshold. If the detected current strength is between the first and second threshold, the output is an oscillating "0/1" at a frequency, e.g. at least 5Hz or 10Hz and/or less than 100Hz or 200Hz, e.g. 20Hz. The detected current may be unipolar or bipolar.

The instrument e.g. has means to adapt its first and second threshold automatically and/or continuously, based on the measured current levels. To be able to do so, the instrument e.g. starts with a calibration cycle to adapt the first and second threshold level to the local situation.

The minimum electrical current difference that can be detected by the instrument is e.g. less than 10mA or 5mA.

The total magnetic field the magnetic field sensor experiences is a function of the external magnetic field (in particular parallel to the sensor coil) and the magnetic field established by the current running through the electrical circuit of the current clamp. By associating the sensor within the current clamp with an oscillation circuit comprised within the current clamp, it is possible to do a current detection since the oscillation rate or period depends from the level of the current flowing through the electrical wire (in here also called "electrical lead" or "wire" or "lead") that is enclosed by the current clamp.

With the current clamp, by measuring the time to complete a fixed number of oscillations (periods) that occur (or by measuring the number of oscillations that occur within a fixed time span), e.g. in the forward and reverse polarity directions, and taking the difference between these two values, it is possible to derive the strength of the external magnetic field. The instrument is provided with electrical means for this, e.g. computer means, to which the sensor is electronically or electrically connected.

E.g., the circuit is designed, e.g. by proper selection of the bias resistance, RB, and/or drive voltage on the Schmitt Trigger, VS, such that the sensor's magnetic field is in the non-linear regime of the permeability curve. Further, the design is e.g. such that the inductance will increase when the circuit is positively biased and will decrease when negatively biased; and/or the period between cycles increases for the positively biased circuit and decreases for the negatively biased circuit.

E.g., the sensor provides an inductive element and/or comprises a coil, e.g. of solenoidal-geometry, e.g. wrapped around a core of, e.g. high-permeability, magnetic or magnetizable material. The inductance of a highly permeable magnetic material will vary with the applied magnetic field. The sensor's inductance is a function of the total magnetic field as experienced by the sensor, which is e.g. caused by application of a core of high-permeability magnetic material. E.g. the coil comprises at least 100 or 500 or 1000 turns of electrical wire in electrical circuit with the oscillator circuit. E.g. the core is of elongate, e.g. straight or linear shape and/or shows non-linear relation between permeability and magnetic induction (e.g. high permeablity at low magnetic induction and low permeablity at high magnetic induction).

E.g., the sensor is associated with a simple resistor-inductor circuit that does not use an analogue-to-digital (A/D) converter. The operating principle of the sensor involves measurement of the time it takes to charge and discharge an inductor between an upper and lower threshold by means of a, e.g. Schmitt trigger, oscillator. This time is proportional to the applied magnetic field strength, within a specified operational range.

E.g., the operation of the instrument is based on the principle such that, when no external magnetic field is present, the charge and discharge results, e.g. times, calculated at both polarities are the same (i.e. the number of oscillations (periods) that occur within the fixed time span is the same for both polarities or the time span for a fixed number of oscillations to occur is the same for both polarities), thus the forward and reverse results are symmetrical. However, if an external magnetic field is present, caused by current flowing though the electrical wire with which the instrument is associated, asymmetry is introduced (e.g. the working region along the induction curve of the sensor or its sensing coil will be shifted in one direction (forward or reverse), and consequently the charge and discharge results, e.g. times, will no longer be equal. This results, e.g. time, difference is proportional to the strength of the detected external magnetic field caused by the electrical wire.

E.g., the operation of the instrument is based on the principle such that the frequency of the oscillation is changed by the external magnetic field that is superimposed to the in polarity changing magnetic field generated by the coil of the sensor itself, such that asymmetry is introduced.

An external magnetic field e.g. causes a constant offset in the coils' field strength, and its polarity is determined by the direction of the field. This offset causes the average permeability and therefore inductance to be lower in one direction and larger in the other, yielding a corresponding difference in the result (e.g. the time required to complete the oscillation loops in each direction). By integrating over many such loops in each direction, the result, e.g. time, difference, and therefore available resolution, can be enhanced to any desired level subject to integrated noise sources.

E.g., the instrument is provided with a computer register (also called cycle count) in data communication with the oscillation circuit. E.g. the number of loops used for integration is controlled by this computer register. The value of this register is e.g. inversely proportional to the sampling frequency, e.g. approximately 40Hz.

The lack of an A/D converter and/or an amplifier (e.g. as required in fluxgate magnetometers), reduces the power consumption, the mass and the size.

Production in large numbers is feasible. High stability (i.e. the instrument provides a constant output while variations of the external magnetic field (i.e. the "input") are absent, thus is constant). High linearity (i.e. a change in the strength of the external magnetic field (i.e. the quantity being measured) must produce a proportional change in the output of the instrument, with the proportionality being maintained throughout the whole range of the instrument.

E.g., the amplitude of the signal changes with increasing frequency of the external magnetic field due to the change in the impedance of the sensing coil.

Magnetic shielding is e.g. applied, e.g. by a wrapping or envelope or housing of ferrite or equivalent magnetic shielding material, to shield from external magnetic fields, e.g. the earth magnetic field and/or the magnetic field created by a component inside the box or cabinet or housing, e.g. a relay, of created by a passing train or the overhead catenary or electricity supply line for the train. Ferrite means here ferrimagnetic material, e.g. of the general chemical formula MeFe2O4, wherein Me stands for at least one bivalent metal (comprising the group: Mn, Zn, Ni, Co, Cu, Mg), Me is e.g. MnZn or NiZn. This magnetic shield e.g. has a solid wall thickness of at least 5 or 7.5 or 8 millimetre and/or provides a cylindrical body around the field sensor, e.g. a ring or bead.

By providing the instrument with two field sensors and associated oscillator circuit, the field sensors positioned at opposite sides of the electrical supply lead and thus detecting the magnetic field of the lead in mutual opposite directions, and e.g. by locating both field sensors in very close proximity of the lead, e.g. less than 1 or 2 or 3 millimetre, the magnetic field of the lead is amplified and other magnetic fields are erased, by adding the output signals of the sensors.

The field sensor is e.g. located at less than 1 or 2 or 3 millimetre from the electrical lead. The instrument is e.g. located at less than 30 or 50 or 75 centimetre from the associated relay, this distance being the shortest distance between the instrument and the relay or the distance measured along the wire onto which the instrument is applied.

The lead, e.g. comprising an insulation jacket or coating or envelope, onto which the instrument is provided is e.g. a wire of round or flat cross section having a cross sectional area e.g. less than 2 or 1 square millimetre and/or at least 0.25 or 0.50 square millimetre, e.g. of type 1.0 or 0.75 square millimetre or smaller, which dimension relates to the external diameter of the lead with or without the insulation jacket or coating or envelope.

The output of the circuit is e.g. inherently digital and is directly related to the applied external magnetic field. Very high resolution, on the order of 10 nT, can be obtained without the need for costly components. The low power consumption is inversely proportional to the sample rate. No need to set/reset the sensor. The reverse/forward biasing nature of the circuit provides temperature stabilized output since changes in the bias resistance or inductance due to temperature are experienced in both the forward and reverse directions, and are thus cancelled and this also avoids or minimizes hysteresis.

For a more detailed discussion of magneto-inductive technology, see Slawomir Tumanski's article "Induction coil sensors - a review" in Measurement Science and Technology, 18 (2007) R31-R46, the contents of which document is enclosed in here by reference. Also, see Leuzinger, A. and Taylor, A.: Magneto-Inductive Technology Overview, Tech. rep, PNI Sensor Corporation, 2010, the contents of which document is enclosed in here by reference.

The circuit e.g. communicates electronically by wire or wireless with one or more of, indeed or not in the current clamp integrated, an ASIC controller with peripheral electronics; computer processor; electronic memory.

E.g., the current clamp is via a wired or wireless (e.g. RF) link connected to an input of a computer of a relay position monitoring system, so that the measurement signal of the current clamp can be fed to the computer for processing.

For the current clamp e.g. one or more of the following applies: e.g. of the bipolar type; is placed outside the relay housing; is located inside the relay box or relay cabinet.

The current clamp is e.g. equipped with a microcontroller or similar computing device, provided with a memory in which e.g. a stored reference value with which the signal coming from the detector is compared in order to determine, on the basis thereof, the relay position.

Surprisingly, the current clamp is suited for its task. The inventor had thoughts about the suitability, partly based on the knowledge developed by the inventor that a relay during switching generates a momentary magnet peak and the inventor feared that this would cause a measurement interference in a current clamp. This not from the state of the art known phenomenon, was established by the inventor experimentally by chance from a field test with B relay of different, in the Netherlands typical, type according to a representative test. With 75% of the tested B relay the result turned out to not match with the predictions based on research on laboratory scale. Initially this was a disappointing result which caused to stop the development of this current clamp. In a subsequent test the offending phenomenon was disappeared inexplicably. Further investigation showed that in the later test a current clamp was used wherein the mutual position of the magnetic shielding and the field sensor was slightly changed. Next, by meticulous research in the laboratory, arose the knowledge why such slight mutual position change does not cause interference. Tolerances of the level of the supply voltage, galvanic property of components (such as the magnetic coil) of the relay and dimension tolerances of the current clamp and the associated supply lead appear to lead to unstable result of the detection by the current clamp. The fault, which could be called "contra pulse in the magnetic field", is incorrectly interpreted by the microcontroller as the relay switches. However, by properly positioning of the magnetic shielding relative to the field sensor, this fault is avoided.

E.g., the current clamp, in particular of bipolar type, is applied to a direction sensitive relay. It is determined that a direction sensitive relay, in particular, shows the magnet peak during switching.

The current clamp e.g. includes an electronic filter which is connected to the detector so that the signal coming from the current clamp is first filtered prior to being fed into the microcontroller. This filter is e.g. one or more of a high-pass, low-pass or band-pass filter.

E.g. one or more of the following applies to the instrument: the instrument comprises a magnetic shielding and/or a sensor part; the magnetic shielding is a separate part of the instrument; the magnetic shielding can be opened, e.g. by pivoting along a pivot line parallel to the axial direction, to release the sensor part that contains one or more of the field sensor, oscillator circuit, computer; the magnetic shielding provides a sleeve of magnetic shielding material, e.g. of cylindrical shape, around the sensor part; the sensor part has an elongated, e.g. cylindrical, shape; the instrument or sensor part provides a, e.g. internal, track, e.g. groove or channel, for the lead; the lead, or the track for it, extends axially through the instrument or sensor part, e.g. such that the lead or track debouches at one or both longitudinal end faces (facing in axial direction) of the instrument or sensor part; by fastening means, e.g. integrated with the instrument or sensor part, the lead is attached to the instrument or sensor part, e.g. by locating a length part of the lead in an axially extending groove or channel in the instrument or sensor part, e.g. extending the complete length of the instrument or sensor part; the track and the fastening means are integrated; the track is internally of the sensor part; the fastening means are designed to fasten the lead to the instrument such that a continuous length part of the lead, e.g. of length at least 20 or 30 or 40 millimetre, is kept immovably relative to the instrument; the fastened length part of the lead is forced by the fastening means of the instrument to follow axially, e.g. for a length of at least 20 or 30 or 40 millimetre, a non-straight path, e.g. helix or partly helix or S or serpentine shape to release from the fastening means, e.g. since the groove has such axial shape; the fastening means are designed such that the fastened length part of the lead has a straight extension in axial direction during operation of the instrument, e.g. the track, holding the lead during operation, has a straight extension in axial direction; the fastening means provide fixed or movable or rigid retaining means, e.g. continuously, extending axially along the instrument or sensor part for a length of e.g. at least 20 or 30 or 40 millimetre; the fastening means provide part of the external surface of the sensor part; the fastening means keep the lead wedged or clamped or enclosed over its complete length part or at least 50% or 75% or 90% of it; the lead has a tight fit in the track, for its complete length part or at least 50% or 75% or 90% of it; the track debouches for its complete axial length at the external surface of the sensor part, as with an axial groove made in an external surface of an object; the length of the sensor part is such that it projects beyond the magnetic shielding at both axial ends for at least 5 or 10 millimetre; the sensor part has projections and/or recesses at the surface that are designed to engage corresponding recesses and projections at the magnetic shielding such that these components are mutually kept immovably by mechanical means against axial movement and rotation; there is an axially extending seam or gap between the two superimposed shell halves of the magnetic shielding; mechanical means are provided that ensure that the magnetic shielding or its seam does not change position relative to the sensor part; the sensor part is straight and/or elongated, e.g. rod shaped, e.g. is made from two superimposed elongated, e.g. rod shaped, halves, also providing an axially extending seam or gap between them; the track is part of only one halve; a or all field sensors are fastened to the one halve and project into the other halve; the track is provided with two windows, directly opposite each other, to locate the field sensors; the field sensors sandwich the track between them; the seam of the magnetic shielding and the sensor part overlap; the magnetic shielding provides a cylinder around the sensor part; the parts of the instrument, in particular the magnetic shielding and the sensor part, have tight fit; the instrument can be released from the lead by first opening the magnetic shielding, second removing the sensor part radially from within the magnetic shielding, third removing the lead radially from the sensor part, wherein step three could immediately follow step one, and the instrument can be provided to the lead by carrying out the steps in reversed order; all electrical components of the instrument are provided in one of the two rod halves of the sensor part; the fastening means for the lead, e.g. groove or channel, are provided in the other of the two rod halves of the sensor part; the fastening means have a dimension to tightly fit a wire of round or flat cross section having a cross sectional area e.g. less than 2 or 1 square millimetre and/or at least 0.25 or 0.50 square millimetre, e.g. of type 1.0 or 0.75 square millimetre or smaller; in case of two field sensors positioned at opposite sides of the electrical supply lead and thus detecting the magnetic field of the lead in mutual opposite directions, the distance between these sensors is such that the widest part of a lead having a wire of round or flat cross section and having a cross sectional area e.g. less than 2 or 1 square millimetre and/or at least 0.25 or 0.50 square millimetre, e.g. of type 1.0 or 0.75 square millimetre or smaller, fits between them with a gap of less than 1 or 2 or 3 millimetre and/or these sensors are part of projections, or provide projections, between which the lead or its track fits, e.g. with a gap of less than 1 or 2 or 3 millimetre; the bottom of the track or groove or channel is closer to the radial centre than the radial surface of the sensor part or instrument; the track or groove or channel is accessible for the lead without opening the sensor part; one or more of the sensor part, the track, the groove, the channel has an axial length of at least 20 or 30 or 40 millimetre and/or less than 100 or 150 or 200 millimetre; the sensor part has a width and/or height (i.e. the dimension perpendicular to the axial direction) of at least 5 millimetre and/or less than 40 or 60 or 100 millimetre; above cross sectional dimension of the wire is with or without the insulation jacket.

The invention will be further described with reference to the drawing. This shows in:
Fig. 1 is a schematic view in perspective of the relay housing, carried by a contact block within a relay box;
Fig. 2 is a perspective view of a B-relay;
Fig. 3-4 an exploded view according to two different viewing directions;
Fig. 5 is a perspective view of a B-relay;
Fig. 6 is a side view of the electrical terminals of a B-relay;
Fig. 7 is a perspective view of a contact block;
Fig. 8 is a front view of a B1 type contact block;
Fig. 9 is a front view of a B2 type contact block;
Fig. 10 an embodiment of the current clamp of the invention, snapped around an electrical lead;
Fig. 11-12 a basic magneto inductive sensing circuit;
Fig. 13 the opened magnetic shielding of the current clamp of fig. 10 in top and end view, typical dimensions also shown;
Fig. 14a-d a top, bottom, end and side view of the sensor part of the instrument of fig. 10;
Fig. 15a-b a perspective view from two angles of the sensor part of fig. 14a-d;
Fig. 16a-d a top, bottom, end and side view of the sensor part as an alternative to the one shown in fig. 14a-d;
Fig. 17a-b a perspective view from two angles of the sensor part of fig. 16a-d;
Fig. 18a-d a top, bottom, end and side view of the one halve of the sensor part of fig. 16a-d;
Fig. 19a-b a perspective view from two angles of the halve of fig. 18a-d;
Fig. 20a-d a top, bottom, end and side view of the other halve of the sensor part of fig. 16a-d;
Fig. 21a-b a perspective view from two angles of the halve of fig. 20a-d;
Fig. 22 a magneto inductive sensing circuit.

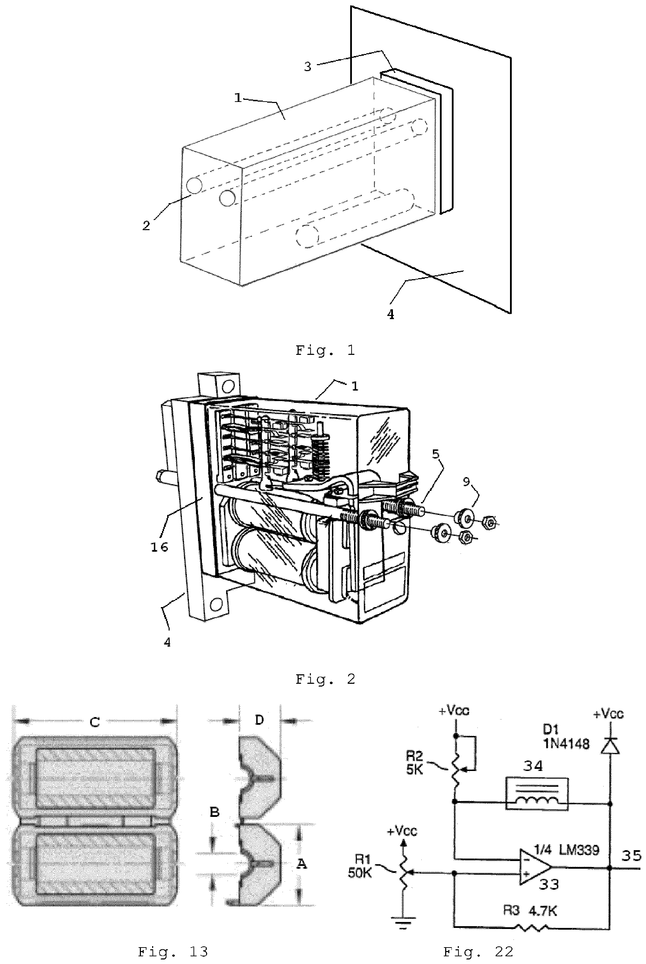

Fig. 1 shows the block-shaped relay housing 1 which hermetically seals a single internal space from the environment. At high level, two parallel, straight mounting sleeves 2 run through the internal space and cross both end walls. These mounting sleeves are sealed with respect to the internal space. A mounting pin longer than the sleeve can protrude from both sides of the tube at both sleeve ends.

The internal space contains all the components of the B-relay, of which only the magnetic coil is shown. This is at a low level. This magnet coil switches the relay and is located at the bottom of the B-relay.

Fig. 1 further shows an adapter plate 3 and a contact block 4. From the contact block 4 (as usual) the two mounting pins (not visible in Fig. 1) are inserted on which the adapter plate 3 and the B-relay 1 are inserted (the mounting pins protrude the mounting sleeves 2) . These mounting pins are rigidly fixed to the contact block 4 and protrude perpendicularly from the contact block, substantially extending horizontally. The adapter plate 3 can be absent. B-relays are available, for example, from Alstom Signaling Inc., West Henrietta, NY, USA (www.alstomsignalingsolutions.com) .

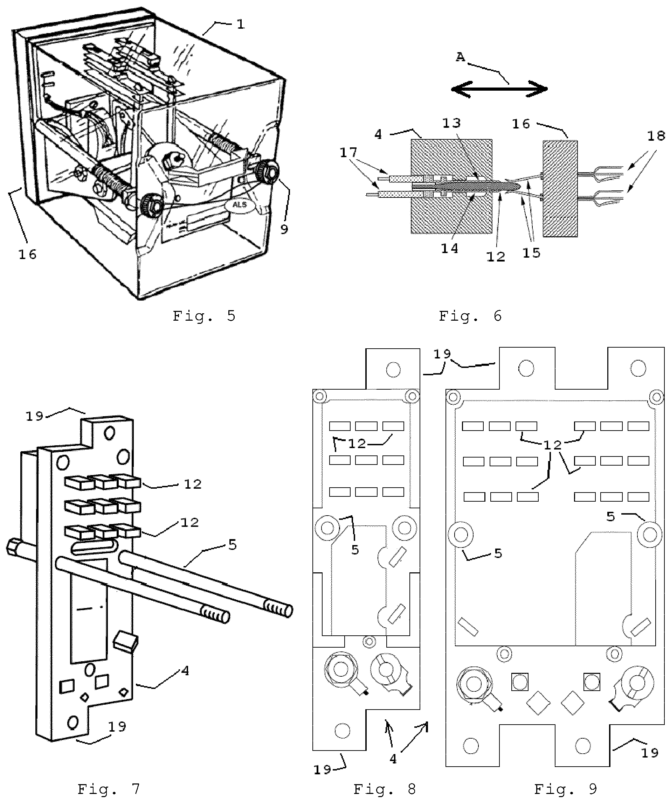

Fig. 2 shows the block-shaped, hermetically sealed relay housing (of transparent plastic, with the exception of the rear wall 16) and now also the most components of the B-relay (type B1) inside this relay housing, including: a galvanic magnet coil with a soft iron core, an anchor, a return spring of the anchor, a change-over contact, a make contact, a break contact. The mounting sleeves are also visible. The B-relay is directly mounted on a contact block 4. FIG. 8 shows a B-relay of B2 type.

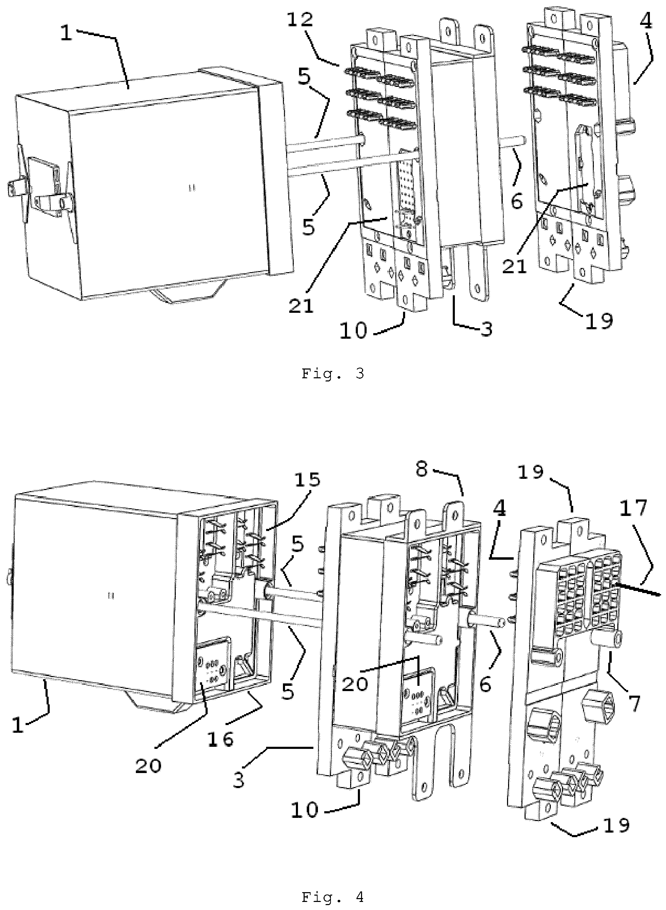

Fig. 3-4 give a better representation of the relay housing 1 and the contact block 4 and the adapter 3, if present. The front side of the adapter 3, that is to say the side facing the B-relay 1, has an embodiment in shape and contact plugs which allows the B-relay 1 to be electrically and mechanically coupled to the adapter 3, respectively the back of the adapter 3 has an embodiment in form and contact ports which allows the contact block 4 to be electrically and mechanically coupled to the adapter 3 as in the known manner that the B-relay 1 with the contact block 4 is electrically and mechanically coupled. E.g. the front of the adapter 3 is identical to the front of the contact block 4 and the back of the adapter 3 is identical to the back of the B-relay.

The adapter 3 shown in Fig. 3-4 is provided with mounting pins 5 which replace the usual mounting pins on the contact block 4. The mounting pins 5 are permanently fixed to the adapter 3 and project from the adapter 3 to its side facing the relay 1. For the purpose of mutual assembly, these pins 5 project into the mounting sleeves 2 of the relay 1. Mounting pins 6 stabbing from the adapter 3 on its side facing the contact block 4 facing side and are for the purpose of the mutual fitting inserted into mounting sleeves 7 of the contact block 4. In an alternative, the pins 6 and the sleeves 7 are missing.

The adapter is equipped with lips 8 for mounting by fixing means (not shown) to the contact block 4.

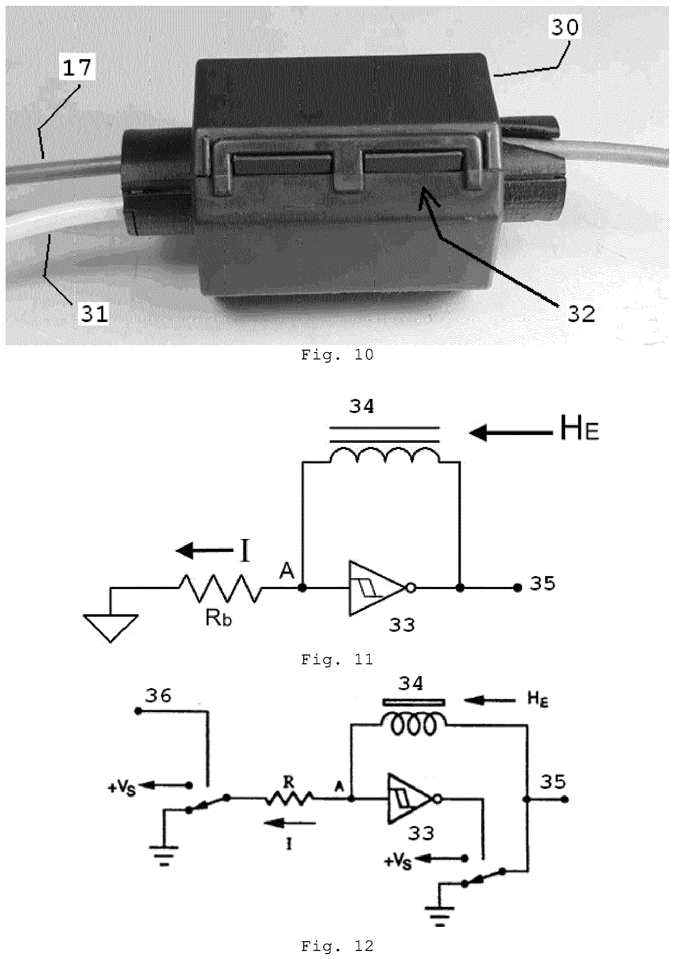

Fig. 3 shows the coding pins 21 at the front of the adapter 3 and the contact block 4. FIG. 4 shows the matching coding holes 20 at the back of the relay 1 and the adapter 3. Fig. 4 also shows the electrical wires 17 (one of which is shown) that protrude from the back of the contact block 4. The instrument 30 (viz. fig. 10) is designed to be located around a such wire 17.

Fig. 9 shows the conventional electrical plug connection between the B-unit and the contact block 4. The arrow A indicates the direction in which the connector terminal is made broken, respectively, by moving in the arrow direction with respect to each other of the housing 1 and the contact block 4. On the rear of the rear wall 16 of the relay are contact ports each of which is formed by a respective pair of contact lips 15 (prongs) protruding from the back wall 16. Each contact lip 15 fits onto an associated contact plug, which is provided by an electrically insulated, wedge-shaped pin 12 which projects from the front side of the contact block 4. The pin 12 has an upper contact (top terminal) 13 and a lower contact (bottom terminal) 14 to each of which its own electricity wire 17 is connected. The electrical wires 17 protrude from the back of the contact block 4. Each contact lip 15 is electrically connected to its own relay contact 18 located inside the housing 1 and mounted at the front of the rear wall 16. The contact lips 15 are biased elastically towards each other and are pushed away from each other by the pin 12 so that they elastically clamp the pin 12 between them. The one contact lip 15 makes electrical contact with the upper contact 13, the other contact lip 15 makes electrical contact with the lower contact 14. The electric currents of the relay contacts 18 to the wires 17 are thus electrically isolated from each other.

Fig. 10 shows a contact block 4 known per se with the pins 5 to which the relay is inserted, and the contact plugs 12. The contact plugs 12 are arranged in three (at least two) horizontal rows and three (at least two) vertical columns.

In fig. 10, the instrument 30 is clipped onto the lead 17 (viz. fig. 4 and fig. 6) with insulation jacket. The lead 31 is for the external supply and data communication of the electrical circuit within the instrument 30. By releasing the snap fitting 32, the implement can be folded open to be removed from the lead 17 in radial direction.

In fig. 11 and 12, HE represents the external magnetic field parallel to the coil. The total magnetic field H the field sensor 34 experiences, is a function of the external magnetic field and the magnetic field established by the current I running through the circuit. The Schmitt Trigger 33 provides the oscillation of the signal within the circuit with output 35 and bias polarity 36.

In fig. 13, B is the diameter of the straight groove in which the sensor part tightly fits. The length of the sensor part is such that it projects beyond the magnetic shielding at both axial ends for at least 5 millimetre (viz. fig. 10). Example: A=38.6, B=18.35, C=47.5, D=19.15 millimetre.

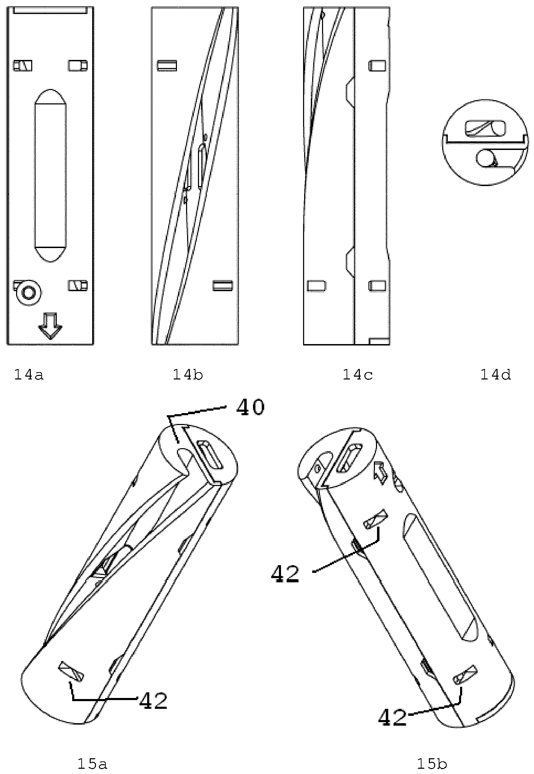

Fig. 14-15 show an example of the instrument wherein the lead is initially forced to follow, when the lead is inserted into the sensor part in radial direction, a helix shaped path by a helix shaped track followed by the radially external part of the groove at the external surface of the sensor part. From the external surface of the sensor part radially inward the groove shape smoothly changes into a straight channel.

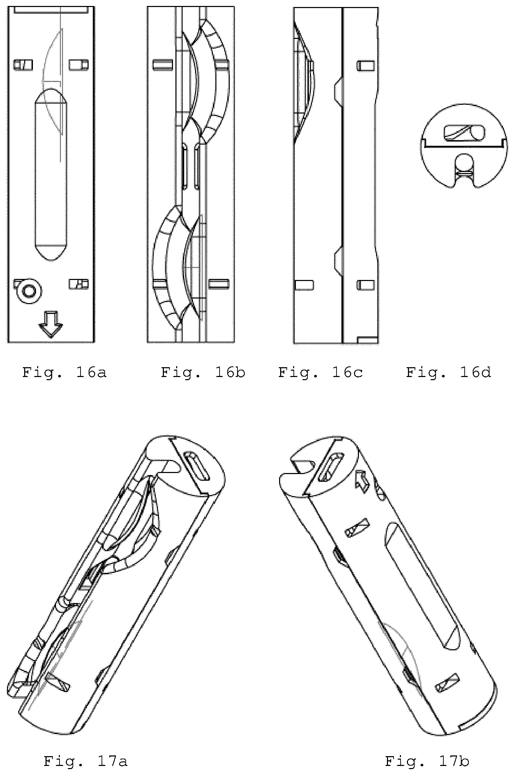

Fig. 16-17 show an example of the instrument wherein the lead is initially forced to follow, when the lead is inserted into the sensor part in radial direction, a S-shaped path by a S-shaped track followed by the radially external part of the groove at the external surface of the the sensor part. From the external surface of the sensor part radially inward the groove shape smoothly changes into a straight channel.

Fig. 14-17 show projections and/or recesses 42 at the external surface that are designed to engage corresponding recesses and projections at the magnetic shielding such that these components are mutually kept immovably by mechanical means. This e.g. ensures that the seam or gap between the two superimposed shell halves of the magnetic shielding does not change position relative to the sensor part. The sensor part is made from two superimposed rod halves, also providing a seam or gap. The seam of the magnetic shielding and the sensor part overlap.

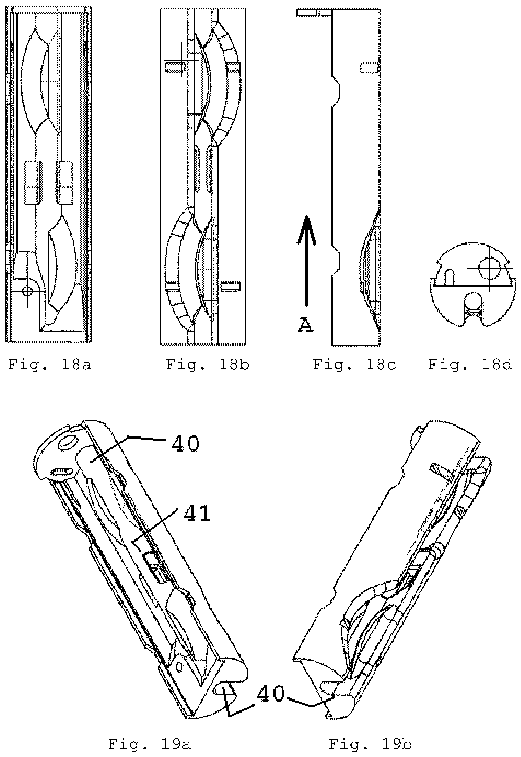

Fig. 18-19 show the straight track 40 to house the supply lead. To be able to enter this track in radial direction from outside the sensor part, the lead must first take a curved shape since at the external surface of the sensor part, the opposite track walls follow a curved shape, viewed axially. The track has two windows 41 straight opposite each other where the field sensors become located.

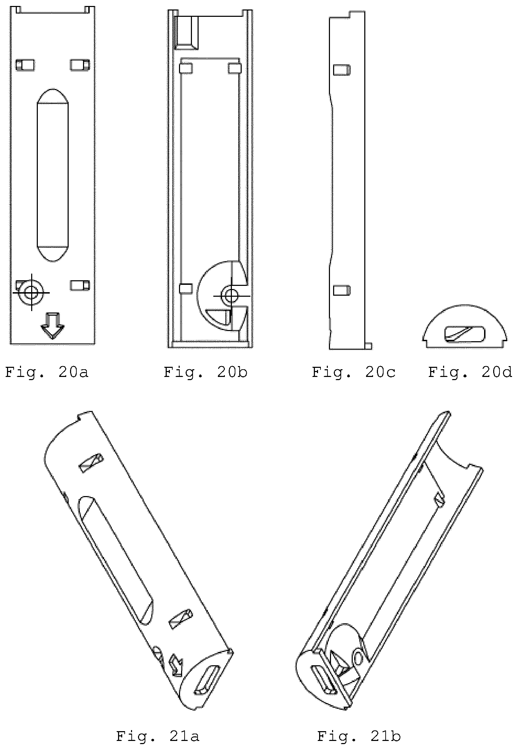

The other halve (fig. 20-21) provides space to house all electronic components (not shown), including the field sensors (not shown) that protrude from this halve into the opposite halve. Fig. 22 shows variable resistors R1, R2, resistor R3, sensor coil 60, electrical wires 28 (connected to a computer processor), 62, 64, 66, diode D1, and oscillator means 56.

The measures disclosed herein can be taken together individually in any other conceivable combination and permutation to provide an alternative to the invention. Included are also technical equivalents and genuses or generalizations of the revealed measures. A measure of an example is also generally applicable within the scope of the invention. A measure disclosed herein, e.g. of an example, can be readily generalized for inclusion in a general definition of the invention, for example to be found in a patent claim. E.g. one or more of: electrical lead that is magnetically associated with an instrument having a magnetic field sensor electrically connected to an electrical circuit that operates according to the magneto inductive principle, to measure the current flowing through the lead; method for adapting an existing one relay, such as B-relay, implementation in for example a with a railway associated relay house or relay box, wherein an instrument, having a magnetic field sensor electrically connected to an electrical circuit that operates according to the magneto inductive principle to measure the current flowing through the relay or through an electrical supply lead of the relay, is fixed to the electrical supply lead of the relay without disconnecting the lead and/or without taking the railway component or object, e.g. switch, with which the B-relay is associated, out of service; device or method, in which the relay box or the relay house is associated with a railway, in particular comprises relays which are applied at security level in the control and checking of switches or crossings or are used for track occupancy reporting, such as a so-called repeat relay; measuring the electrical current that flows through an electrical lead that is magnetically associated with an measuring instrument having a magnetic field sensor electrically connected to an electrical circuit that operates according to the magneto inductive principle; relay or its electrical supply lead, magnetically associated with an instrument having a magnetic field sensor electrically connected to an electrical circuit that operates according to the magneto inductive principle to measure the current flowing through the relay or through the electrical supply lead of the relay; instrument designed to be magnetically associated with an electrical lead or relay, the instrument having a magnetic field sensor electrically connected to an electrical circuit that operates according to the magneto inductive principle to measure the current flowing through the relay or through the electrical lead.

Everywhere, the meaning of "e.g." could also be "for instance" or "preferably".

## Claims

1. A method for monitoring the correct operation or position of a railway object, e.g. switch of a railway with, e.g., rails type UIC 60 and/or a track width 1435 (+ 2 / -0) mm, of a rail track for passenger and freight per train with overhead contact line above the track for the electrical supply of the train locomotive, of which the train protection system uses and is equipped with safety relays placed in relay boxes and relay houses, so-called B-relays each located inside an individual sealed housing and mounted onto a contact block, wherein e.g. the left and right end position of the railway switch is monitored;
within the present method, one starts with the existing train protection system, and at the beginning of the implementation of the method modifications are carried out inside the already for some time prior to the start of the implementation of the method adjacent the railway track disposed relay box/housing of this existing train protection system by locating for the B relay, which monitors the railway object, an, e.g. own and/or individual, monitoring sensor permanently inside the relay box/housing, in which the B-relay is located, said permanent monitoring sensor detects and/or monitors the position "up" and "off" of the associated B-relay and, by way of a data connection, transmits the status of these positions to an associated and remote central monitoring computer of the existing train protection system which is designed to use the data from the permanently placed monitoring sensor to conclude about the position or operation of the railway object;
such that at the start of implementing the method, this relay box/house is modified by permanently locating inside it the monitoring sensor which is associated with the B-relay; wherein the permanent located monitoring sensor is mounted to an already present and connected, outside the housing of the B-relay located, electrical supply lead, provided with an electrically isolating jacket and which lead supplies the B-relay with electrical current, wherein the monitoring sensor is mounted without releasing the supply lead from the associated electrical circuit and such that the isolating jacket of the supply lead is unaffected and without interrupting the supply of the B-relay through this supply lead and without taking the associated railway object out of service;
the supply lead is electrically connected to the relevant contact means of the contact block with which the B-relay is associated;
in this manner one detects in an indirect way the position or operation of the railway object by, with the aid of the at the beginning of carrying out the method inside the relay boxes/houses located and with the B-relay of the existing train protection system associated permanent monitoring sensor, monitoring of the state of the already prior to the carrying out of the method in the relay boxes/houses along the railway track present B-relay, in which the position (i.e., "on" or "off") of said B-relay is due to the position or operation of the associated railway object;
the central monitoring computer receives updates from the permanently placed monitoring sensor, such that the status is known of the associated B-relay and in this manner the central monitoring computer can monitor the correct position or operation of the railway object;
a modification inside the housing of the B-relay does not take place and the housing of the B-relay remains unaffected; wherein the monitoring sensor is of the so called non invasive type;
**characterised in that** one or more of the following applies to the monitoring sensor;
- operates according to the magneto inductive principle comprising a magnetic field sensor, preferably designed as two identical assemblies that each operate according to the magneto inductive principle of which the field sensor is in circuit with a bias resistance, to measure the electrical current that flows through the electrical supply lead towards the B-relay;
- has a length between 40 and 150 millimetre and a width and height between 5 and 75 millimetre;
- its electrical circuit is designed as an oscillation circuit of L/R type and has an element, e.g. a Schmitt Trigger, to supply a clock frequency and an oscillating electrical signal of e.g. rectangular wave shape;
- the bias resistance and the field sensor are connected in series, per assembly;
- provides, determined by the detected current level in the supply lead, three output levels: "0", "1" and ""0/1" oscillating with at least 5 Hz;
- the time is measured to complete a fixed number of oscillations that occur in the forward and reverse polarity directions, and the difference between these two values is determined, and from this the strength of the current flowing through the supply lead is derived;
- the coil of the field sensor of it generates a magnetic field and the magnetic field of the supply lead is added to this and this introduces asymmetry in the oscillation and from this the current level in the supply lead is derived;
- the field sensor of it has a distance of less than 3 millimetre to the supply lead;
- located at less than 50 centimetre from the associated B-relay, measured along the supply lead;
- located outside the housing of the B-relay and inside the relay box/housing.

2. A relay box or house or cabinet which is associated with a railway for civil train transport and which contains a large number, e.g. at least five or ten or fifteen, of relays of which at least one, or all, relays is magnetically associated with an instrument, e.g. monitoring sensor, having a magnetic field sensor electrically connected to an electrical circuit that operates according to the magneto inductive principle to measure the current flowing through the relay or through an electrical supply lead of the relay.

3. Method or device according to claim 1 or 2, the core of the field sensor of the monitoring sensor has an elongated, straight shape and/or has non-linear relation between permeability and magnetic induction.

4. Method or device according to any of claims 1-3, the field sensor of the monitoring sensor is fixedly mounted to a sensor part having a rigid, elongated, straight shape and a permanently open recess along the complete length into which the supply lead is fixedly clamped for a length of at least 40 millimetre between the opposite walls of the recess such that the fixedly clamped part of the supply lead, inside the sensor part, extends parallel to the longitudinal direction of the sensor part and is immovable relative to the sensor part.

5. Method or device according to any of claims 1-4, the field sensor of the monitoring sensor has magnetic shielding by an envelope of magnetic shielding material.

6. Method or device according to any of claims 1-5, two field sensors of the same monitoring sensor are located at opposite sides of the supply lead such that they detect the magnetic field of the supply lead in opposite directions, and the output signals of these are e.g. added.
